# EUROPEAN PATENT APPLICATION

(11) **EP 2 103 709 A1**
(43) Date of publication of application: **23.09.2009**
(21) Application number: 08009828.8
(22) Date of filing: 29.05.2008
(51) Int. Cl.: C23C 14/00, C23C 14/04, C23C 14/56

(54) **Backside coating prevention device and method.**

(30) Priority: 28.02.2008 US 32133 P; 28.02.2008 EP 08152074
(71) Applicant: Applied Materials, Inc., Santa Clara, CA 95054 (US)
(72) Inventor: Sauer, Andreas, 63762 Großostheim (DE); Henrich, Jürgen, 63694 Limeshain (DE); Müller, Joachim, 70736 Fellbach (DE)
(74) Representative: Zimmermann & Partner

(57) **Abstract**

A backside coating prevention device (200) adapted for a coating chamber (10) for coating plate-shaped substrates (100), said coating chamber comprising a plurality of walls, a coating material source (26) for dispensing coating material into the coating chamber, a substrate support, a front side of the substrate support facing the coating material source, the substrate support being adapted for supporting on the front side one or more plate-shaped substrates each having a substrate front side and thereby defining a substrate front plane, wherein said backside coating prevention device comprises two or more screens (200), the screens being provided at at least two of the walls of the coating chamber, each screen having a protruding member protruding from the respective wall.

## Description

### TECHNICAL FIELD OF THE INVENTION

The present invention relates to a backside coating prevention device, a coating chamber device for coating plate-shaped substrates, and a method of coating. Particularly, the present invention relates to a backside coating prevention device for a coating chamber for coating plate-shaped substrates, a coating chamber device for coating plate-shaped substrates, and a method of coating plate-shaped substrates.

### BACKGROUND OF THE INVENTION

Thin-film coating of material on plate-shaped substrates may be accomplished in many ways, for example by evaporation or sputtering of the coating material. In some instances, for example in the manufacture of solar cells, it is desirable to coat exclusively one surface of the plate-shaped substrates.

In known installations for coating continuously conveyed plate-shaped substrates, typically glass substrates, with thin layers by cathode sputtering, several compartments are located one after another. Each compartment comprises at least one sputtering cathode and process gas inlets, and is connected with a vacuum pump for evacuation. The compartments are connected to one another by means of openings, typically vacuum locks or airlocks, which may include one or more slit valves. A transport system including transport rolls for transporting the plate-shaped substrates along a path below the sputtering cathodes and passing the substrates through the openings between the compartments is provided.

When operating a sputtering cathode, a plasma is established and ions of the plasma are accelerated onto a target of coating material to be deposited onto the substrates. This bombardment of the target results in ejection of atoms of the coating material which accumulate as a deposited film on the substrate below the sputtering cathode.

In known designs of a compartment for sputtering and thereby coating continuously transported rectangular plate-shaped substrates, coating material may deposit not only on the front sides of the plate-shaped substrates as desired, but also on the backsides thereof, which is especially undesirable for glass substrates for solar cells.

### SUMMARY OF THE INVENTION

In light of the above, the backside coating prevention device according to independent claim 1, the coating chamber device according to independent claim 2, and the method of coating plate-shaped substrates according to independent claim 10 are provided.

One embodiment is directed to a backside coating prevention device adapted for a coating chamber for coating plate-shaped substrates, said coating chamber comprising a plurality of walls, a coating material source adapted for dispensing coating material into the coating chamber, a substrate support, a front side of the substrate support facing the coating material source, the substrate support being adapted for supporting on the front side one or more plate-shaped substrates each having a substrate front side and thereby defining a substrate front plane, wherein said backside coating prevention device comprises two or more screens, the screens being provided at at least two of the walls of the coating chamber, each screen having a protruding member protruding from the respective wall.

According to another embodiment, a coating chamber device for coating plate-shaped substrates is a coating chamber comprising a plurality of walls, a coating material source adapted for dispensing coating material into the coating chamber, a substrate support, a front side of the substrate support facing the coating material source, the substrate support being adapted for supporting on the front side one or more plate-shaped substrates each having a substrate front side and thereby defining a substrate front plane, and a backside coating prevention device comprising two or more screens, the screens being provided at at least two of the walls of the coating chamber, each screen having a protruding member protruding from the respective wall.

In a further embodiment it is provided a method of coating plate-shaped substrates in a coating chamber, comprising providing a plate-shaped substrate on a substrate support of the coating chamber, dispensing coating material from a coating material source provided in the coating chamber towards the plate-shaped substrate, and simultaneously preventing backside coating by two or more screens, the screens being provided at at least two walls of the coating chamber, each screen having a protruding member protruding from the respective wall.

Further advantages, features, and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

It is contemplated that elements of one embodiment may be advantageously utilized in other embodiments without further recitation.

### BRIEF DESCRIPTION OF THE DRAWINGS

So that the manner in which the above recited features of the present invention can be understood in detail, a more particular description of embodiments of the invention, briefly summarized above, may be had by reference to embodiments. The accompanying drawings relate to embodiments of the invention and are described in the following. Some of the above mentioned embodiments will be described in more detail in the following description of typical embodiments with reference to the following drawings in which:

Fig. 1 shows a cross-sectional view of a coating chamber including a backside coating prevention device according to embodiments described herein.

Fig. 2 is an enlarged cross-sectional view of a screen of the backside coating prevention device shown in Fig. 1.

Fig. 3 shows a cross-sectional view of a screen of the backside coating prevention device according to embodiments described herein.

Fig. 4a and 4b, respectively, are cross-sectional views of screens of the backside coating prevention device according to embodiments described herein.

Fig. 5a and 5b, respectively, show cross-sectional views of screens of the backside coating prevention device according to embodiments described herein.

Fig. 6a and 6b, respectively, show cross-sectional views of screens of the backside coating prevention device according to embodiments described herein.

Fig. 7a and 7b, respectively, show cross-sectional views of screens of the backside coating prevention device according to embodiments described herein.

Fig. 8a and 8b, respectively, show cross-sectional views of screens of the backside coating prevention device according to embodiments described herein.

Fig. 9a and 9b, respectively, show cross-sectional views of screens of the backside coating prevention device according to embodiments described herein.

Fig. 10 shows a cross-sectional view of a screen of the backside coating prevention device according to embodiments described herein.

Fig. 11 shows a cross-sectional view of a screen of the backside coating prevention device according to embodiments described herein.

### DETAILED DESCRIPTION OF THE EMBODIMENTS

Reference will now be made in detail to the various embodiments, one ore more examples of which are illustrated in the figures. Each example is provided by way of explanation, and is not meant as a limitation of the invention. Throughout the description and in the claims, the coating chamber device may also be referred to as coating chamber.

A typical application of the backside coating prevention device, the coating chamber and the coating method of the invention is in vacuum sputtering compartments of installations for coating continuously or discontinuously conveyed plate-shaped substrates with thin films. The invention is especially useful for coating plate-shaped glass substrates with thin metal films, for example with Ag films, in the manufacture of solar cells.

Without limiting the scope of the invention, the following is directed to a backside coating prevention device in a vacuum sputtering coating chamber for thin-film Ag coating of continuously transported rectangular plate-shaped glass substrates. Embodiments of the present invention can also be applied to other coating methods, such as thin-film vapour deposition, and other coating materials than Ag, e.g. other metals or alloys. Furthermore, other substrates, such as a web or plastic films, having modified shapes may be employed. Moreover, the substrate(s) may be delivered to the coating chamber continuously or may be provided in the coating chamber in a discontinuous mode. In addition, the coating chamber is not limited to a vacuum chamber.

Within the following description of the drawings, the same reference numbers refer to the same components. Generally, only the differences with respect to the individual embodiments are described.

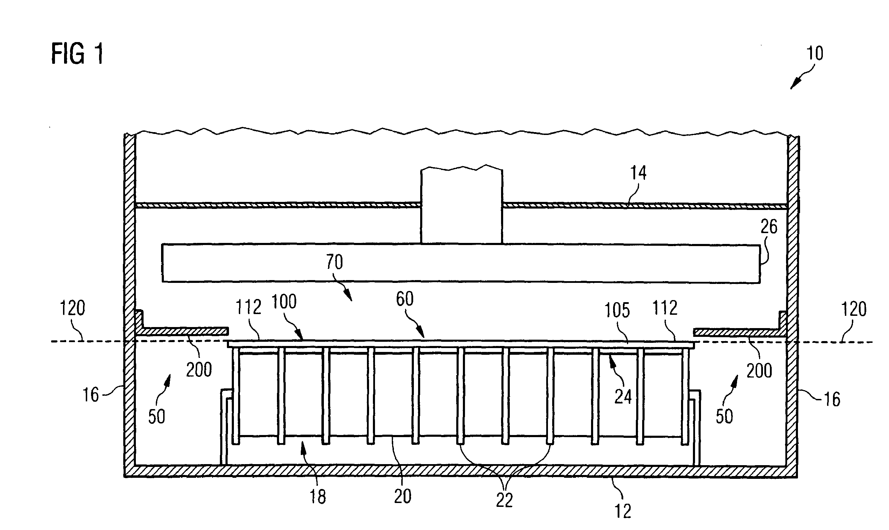

Fig. 1 illustrates a vacuum sputtering coating chamber 10 for thin-film coating of continuously transported rectangular plate-shaped glass substrates 100, including a backside coating prevention device 200, according to embodiments described herein. The coating chamber 10 comprises a bottom wall 12, a top wall 14, a front wall (not shown), a rear wall (not shown) and two opposite sidewalls 16, the material of all walls being stainless steel or normal steel, the coating chamber 10 being vacuum-tight. The front wall includes a substrate feeding opening (not shown) and the rear wall includes a substrate discharge opening (not shown), the openings being designed as vacuum locks or airlocks, typically slit valves, for maintaining a vacuum in the coating chamber when feeding and discharging the glass substrates 100. The coating chamber 10 further has process gas inlets (not shown) and is connected to vacuum pumps (not shown) for establishing a vacuum of up to about 10⁻⁶ hPa (10⁻⁶ Torr). Furthermore, at the top wall 14 a sputtering cathode 26 comprising a target of Ag is provided as a coating material source for dispensing coating material into the coating chamber.

On the bottom wall 12, as a substrate support, a transport system 18 for continuously conveying of glass substrates 100 is mounted. The transport system 18 has a top side 24, also herein referred to as front side 24, facing the sputtering cathode 26 and is adapted for supporting on the front side 24 one or more plate-shaped substrates 100. The transport system 18 comprises a plurality of rotatable rolls 20 arranged successively in parallel to each other throughout the coating chamber 10, extending from one sidewall 16 to the opposite sidewall 16. The rolls 20 are connected to a driving unit and a control unit (both not shown). Each roll 20 has a plurality of spaced apart rings 22 being each concentrically attached to the roll 20. The rings 22 support the glass substrates 100 and, thereby, define a substrate support plane at the front side 24 of the substrate support. As such, the transport system 18 is made for conveying the plate-shaped glass substrates 100 in a transport direction along a transport path 60. The transport path 60 is defined by the transported glass substrates 100 and is located on the substrate support plane below the sputtering cathode 26 and through the substrate feeding and discharge openings of the coating chamber 10.

In an alternative design (not shown in the Figures) of the transport system, the diameter of the plurality of rolls may be much smaller than the diameter of the plurality of rings. Each ring may then be attached to a wheel which is attached to one of the rolls. Hence, each roll may have a plurality of spaced apart wheels being each concentrically attached to the roll. Each wheel may support one ring at the outermost circumference of the wheel. The rings support the glass substrates 100 and, thereby, define a substrate support plane at the front side 24 of the substrate support.

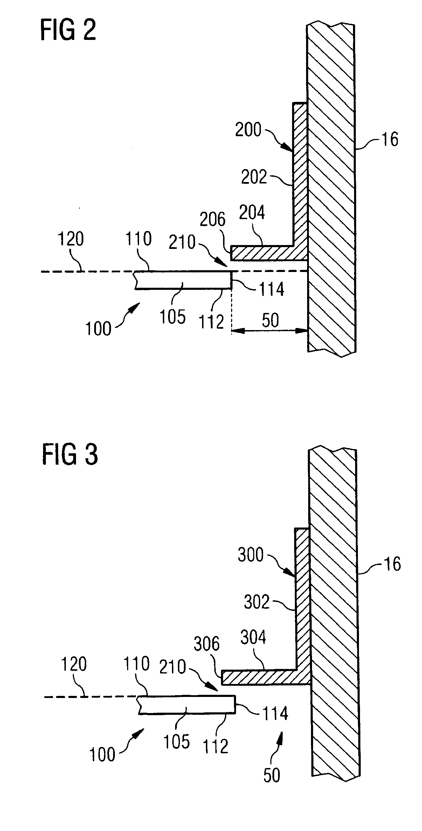

As shown in e.g. Fig. 2, each glass substrate 100 has a substrate front side 110 (also referred to herein as front side 110) to be coated and facing the sputtering cathodes 26 during transport of the glass substrate on the transport system 18. Hence, the front side 110 of each glass substrate 100 defines a substrate front plane 120. The substrate front plane 120 is shown in Fig. 1 as a dashed line. Furthermore, each glass substrate 100 has a backside 105 opposite to the front side 110 and facing the transport system 18 during transport of the glass substrate thereon. In addition, each glass substrate has two lateral ends 112, each comprising a lateral side 114. It is noted that Fig. 2 only shows one of the two lateral ends 112 of glass substrate 100. It will be understood by those skilled in the art that the arrangement shown in Fig. 2 is provided on the opposite lateral side of glass substrate 100 but in mirrored configuration.

A typical example of a material of the glass substrate 100, which may also be referred to as baseline substrate, is soda lime float glass and may have a standard or reduced iron content. In addition, in the embodiments described herein, a pre-coated glass substrate may be used. For example, the glass substrate 100 may be coated with a transparent conductive oxide. Further, the glass substrate 100 may have an amorphous and/or microcrystalline silicon p-in structure or an amorphous and/or microcrystalline silicon p-i-n-p-i-n tandem cell structure. Moreover, in case of coating a substrate for solar cells, substrates having a solar cell layer stack may be used in embodiments described herein. Furthermore, typical dimensions of glass plates used as glass substrate 100 according to embodiments described herein are in the range of about 1x1 sqm to about 3x6 sqm, typically about 2.2x2.6 sqm or about 1.1x1.3 sqm. Typically, the thickness of the glass substrate 100 according to embodiments described herein is in the range of about 2 mm to about 5 mm.

As can be seen from Fig. 1, the sputtering cathode 26 and, hence, the target thereof extend over the lateral ends 112 of the glass substrate, in order to apply a coating of a uniform thickness, e.g. of a substantially constant thickness onto the front side 110 of the substrate 100 over the whole area of the front side 110, i.e. even on the lateral ends 112. During transport of the glass substrates 100, two gaps 50 will be formed between the lateral sides 114 of the rectangular plate-shaped glass substrates 100 arranged on the transport system 18 and the sidewalls 16 of the compartment. These gaps 50 extend along the sidewalls 16 of the coating chamber 10 substantially in parallel to the transport direction. A number of ejected atoms of the target material may pass these gaps 50 and may undesirably be deposited on the backsides 105 of the glass substrates, typically due to scattering.

In view of the above, a backside coating prevention device according to embodiments described herein comprises two or more screens, the screens being provided at at least two of the walls of the coating chamber 10, each screen having a protruding member protruding from the respective wall. As is shown in Fig. 1, one example of such a backside coating prevention device includes two lateral screens 200, each sidewall 16 of the coating chamber 10 being provided with one of the screens 200 above the substrate front plane 120.

Fig. 2 illustrates an enlarged cross-sectional view of one example of the screens 200 of the backside coating prevention device shown in Fig. 1. It is noted that the proportions of the screen 200 and the glass substrate 100 as shown in Fig. 2 are not to scale as compared to the proportions of the screen 200 and the glass substrate 100 as shown in Fig. 1. Each lateral screen 200 is typically made of stainless steel and typically has an L-shaped cross section, i.e. it comprises two branches 202 and 204 arranged substantially perpendicularly to each other. Branch 202 is attached to the interior surface of the sidewall 16 of the coating chamber 10. Branch 204 is provided at the bottom end of branch 202 and protrudes towards the centre of the coating chamber substantially in parallel to the substrate front plane 120, i.e. substantially perpendicularly to the sidewall 16. Therefore, branch 204 forms the protruding member and extends along sidewall 16 substantially in parallel to the transport path 60. The installation height of branch 202 at the sidewall 16 in the coating chamber 10 is such that branch 204 is positioned about 1.5 to about 10 mm, typically about 1.5 to about 5 mm, most typically about 2 mm above the substrate front plane 120. Both branches 202 and 204 of the lateral screens 200 further extend substantially in parallel to the substrate front plane 120 along the sidewall 16 throughout the coating chamber 10, typically at least throughout a sputtering region of the coating chamber 10. That means that the sputtering cathode 26 forming the coating material source is adapted to dispense coating material at least into a coating region 70 of the coating chamber 10 and each screen 200 is provided at least in the coating region 70.

Typically, the material(s) of the screens is (are) vacuum-compatible and may be at least one element selected from the group consisting of Aluminum, an Aluminum alloy, or stainless steel in any of the embodiments described herein. However, other materials which are vacuum-compatible may be contemplated. The thickness of the screens or of the protruding member in any embodiment described herein, e.g. the thickness of any of the branches 202 and 204 in the present embodiment, may for example be a few mm, typically in the range from about 1 mm to about 10 mm, more typically from about 2 mm to about 5 mm. Moreover, in the embodiments described herein, typical dimensions of the protruding member, e.g. the dimensions of branch 204 in the present embodiment substantially in parallel to the transport direction, may be in the range from about 20 cm to about 100 cm. Furthermore, typical dimensions of the protruding member of any embodiment described herein, e.g. the dimensions of branch 204 of the present embodiment substantially perpendicular to the transport direction, may be in the range from about 10 cm to about 50 cm. That means that according to embodiments described herein, the dimensions of the protruding member of the screens may be LxW (Length x Width) = (10-50cm) x (20-100cm), wherein according to particular embodiments the Width W extends substantially in parallel to the transport direction.

In a typical embodiment, the protruding branch 204 is positioned to be about 1.5 mm to about 10 mm spaced apart from the one or more plate-shaped substrates 100 during coating. Furthermore, branch 204 protrudes from the sidewall 16 such that the branch 204 is positioned between the sputtering cathode 26 and the substrate front plane 120. More specifically, as mentioned above, each glass substrate 100 supported on the substrate support plane has a front side 110 and lateral ends 112 each comprising a lateral side 114. As shown in Fig. 2, a gap 210 is formed between the front side 110 of the glass substrate 100 and the lower side of branch 204, branch 204 being about 1.5 to about 10 mm, typically about 1.5 to about 5 mm, most typically about 2 mm spaced apart from the front side 110 of the glass substrate 100, depending on the installation height of branch 202 as explained above. Therefore, gap 210 has a width of about 1.5 mm to about 10 mm, typically about 1.5 mm to about 5 mm, most typically about 2 mm. As a result of this small width, most of the Ag particles sputtered towards the gaps 50 between the glass substrate 100 and the sidewalls 16 are prevented from passing to the backside 105 thereof, since they are deposited on the upper surface of branches 204. The gap 210 between protruding branch 204 and glass substrate 100 also allows for vibrations or sagging of the glass substrate 100 during transport, preventing contact or collisions of the glass substrate 100 with the protruding branches 204 of the backside coating prevention device.

In one variation according to embodiments described herein, the protruding member, e.g. formed as branch 204, has a lateral end protruding into the coating chamber, wherein the lateral end is positioned to be spaced apart from but substantially aligned with one of the lateral sides 114 of at least one of the one or more plate-shaped substrates 100 on the substrate support. In the screen 200 shown in Fig. 2, branch 204 has a lateral end formed as a front face 206. The lateral end of branch 204 is positioned above the substrate front plane 120 and is spaced about 2 mm from the lateral side 114 of glass substrate 100 by gap 210. Simultaneously, front face 206 of screen 200 is substantially aligned with the lateral side 114 of the glass substrate 100 supported on the transport system 18. Therefore, contact or collisions of the glass substrate 100 with the protruding branches 204 of the backside coating prevention device are avoided. Furthermore, Ag particles, which are sputtered towards the gaps 50 between the glass substrate 100 and the sidewalls 16, move along a straight trajectory and may also be deflected or scattered by collisions with other particles or with the sidewalls 16. Because of the alignment of front faces 206 of the protruding branches 204 with the lateral sides 114 of the glass substrate 100, most of the Ag particles, which are laterally sputtered towards the gaps 50 between the glass substrates 100 and the sidewalls 16, are adsorbed or deposited on the upper surfaces and the front faces 206 of the branches 204.

During coating operation, glass substrates 100, typically of substantially identical dimensions, are successively fed into the coating chamber 10 through the substrate feeding opening, continuously conveyed by the transport system 18 along the transport path 60 on the substrate support plane below the operating sputtering cathode 26, and discharged through the substrate discharge opening. Consequently, since the plate-shaped glass substrates have typically the same thicknesses, the front sides of the glass substrates define a common substrate front plane. Alternatively, in embodiments described herein, glass substrates of such varying dimensions or thicknesses may be successively fed into the coating chamber 10 that the protruding member of the backside coating prevention device is positioned to be spaced at least 1.5 mm from the one or more plate-shaped substrates during coating. That means in the present embodiment, that branch 204 is about 1.5 to about 10 mm, typically about 1.5 to about 5 mm, most typically about 2 mm spaced apart from the front sides 110 of the glass substrates 100 having varying dimensions and, hence, from the substrate front planes 120 defined thereby. Particles of Ag coating material are ejected from the sputtering cathode 26 towards the glass substrates 100 and also laterally towards the gaps 50 which are formed between the rectangular plate-shaped glass substrates 100 and the sidewalls 16 of the coating chamber 10. Coating particles ejected laterally towards these gaps 50 are mainly deposited on the upper surfaces of the protruding branches 204 of the screens 200. Thereby, passage of Ag particles through the gaps 50 between the glass substrates 100 and the sidewalls 16 towards the backsides 105 of the glass substrates 100 is reduced or substantially inhibited. Moreover, the coating on the front sides of the glass substrates 100 is uniform even at the lateral ends 112 thereof, as is especially desired when glass substrates for solar cells are processed.

A further variation of embodiments is now described with reference to Fig. 3. Like in Fig. 2, a cross-sectional view of only one screen 300 of such a backside coating prevention device is shown. However, typically two lateral screens 300 are included in the backside coating prevention device. Each lateral screen 300 includes two branches 302 and 304 which are arranged as described with respect to the embodiment shown in Fig. 2. However, in the present embodiment the backside coating prevention device includes a protruding member having a lateral end being positioned to extend over a lateral part of the front side 110 of at least one of the one or more plate-shaped substrates 100 on the substrate support. Branch 304 differs from branch 204 shown in Fig. 2 in that the front face 306 of branch 304 is positioned above the glass substrate 100. That means that branch 304 extends over the lateral part 112 of the front side 110 of the glass substrate 100 during transport, i.e. it extends partially over the front side of the transport path 60. Thereby, backside coating of glass substrate 100 is prevented, even if an amount of the Ag particles laterally ejected from the sputtering cathode 26 is deflected or scattered by the sidewalls 16 or other particles towards the gap 210 between the protruding branch 304 and the front side 110 of the glass substrate 100.

In the examples shown in Figs. 2 and 3, respectively, during sputtering an amount of particles of the sputtered Ag material, which are laterally ejected towards the sidewalls 16, is deposited on the surfaces of branches 202 and 302, respectively. As a result, in addition to the backside coating prevention effect of the screens 200 and 300, these embodiments reduce or inhibit contamination of the sidewalls 16 of the coating chamber 10 by Ag particles. Furthermore, maintenance of the coating chamber 10 may include a replacement of the lateral screens 200, 300 without the need for a sidewall cleaning procedure. In particular, the branches 202, 302 may cover sidewall 16 up to the top wall 14 of the chamber.

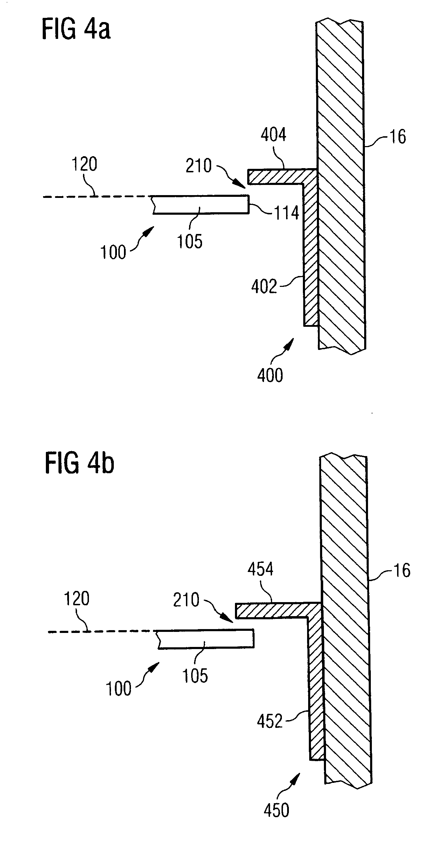

Figures 4a and 4b, respectively, show further examples of backside coating prevention devices according to embodiments described herein. In these examples, L-shaped screens 400 and 450, respectively, of the backside coating prevention device are attached to the sidewalls 16 in an inverted way as compared to the screens 200 and 300 shown in Fig. 2 and 3. That means that a branch 402 of the screen 400 is mounted facing the lateral side 114 of the glass substrate 100 while branch 404 is attached to the top end of branch 402. Branch 402 is mounted to sidewall 16 and extends across substrate front plane 120 into the upper portion, e.g. in the coating region, of the coating chamber. Branch 404 protrudes substantially in parallel to the substrate front plane 120 and is positioned about 1.5 to about 10 mm, typically about 1.5 to about 5 mm, most typically about 2 mm above the substrate front plane 120.

Correspondingly, branch 452 of screen 450 shown in Fig. 4b is mounted facing the lateral side 114 of the glass substrate 100 while branch 454 is attached to the top end of branch 452. Branch 452 is mounted to sidewall 16 and extends across substrate front plane 120 into the upper portion, e.g. in the coating region, of the coating chamber. Branch 454 protrudes partially over the front side 110 of the glass substrate 100 and substantially in parallel to the substrate front plane 120. Branch 454 is about 1.5 to about 10 mm, typically about 1.5 to about 5 mm, most typically about 2 mm spaced apart from the front side 110 of the glass substrates 100 during transport.

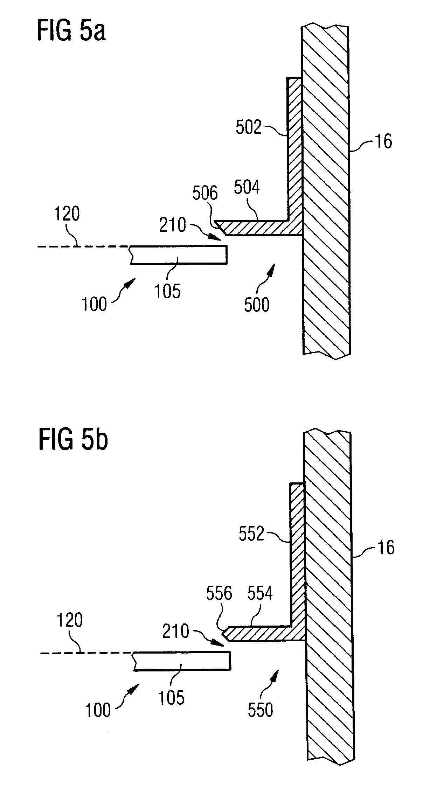

According to a further variation of embodiments described herein, said lateral end of the protruding member of the screen is formed to taper away from the front side of a plate-shaped substrate 100 on the substrate support. In Figs. 5a and 5b, respectively, examples of such a backside coating prevention device are shown, which correspond to the embodiment shown in Fig. 2 except for the design of the protruding lateral ends of the protruding branches. For instance, L-shaped screen 500 of Fig. 5a includes a branch 502 attached to the sidewall 16 and a branch 504 protruding above the substrate front plane 120. The lateral end 506 of branch 504 has a wedge-shaped slanted face such that the protruding tip thereof is directed towards the top wall 14 of the coating chamber 10. Screen 550 shown in Fig. 5b has two branches 552 and 554. Branch 552 is attached to the sidewall 16 while branch 554 protrudes substantially in parallel to the substrate front plane 120. In addition, the lateral end 556 of branch 554 has a tapered form such that the protruding central tip thereof is directed towards the opposing sidewall 16 of the coating chamber 10.

In the examples of Figs. 5a and 5b, since the protruding laterals ends 506 and 556 of the screens 600 and 650 are formed tapering away from the front side of the glass substrate 100, the clearance of the glass substrate 100 during transport is improved. Therefore, contact or collisions of the glass substrate 100 with the screens 500, 550 because of vibrations or sagging of the glass substrate 100 during transport can be avoided more safely while backside coating of the glass substrate is reduced or prevented. Simultaneously, a sufficient width of gap 210 may be provided in the tapered portion of the protruding branches 504, 554 while the bottom surface of these branches 504, 554 is spaced from the substrate front plane 120 less than the sufficient minimum gap width. Thus, the unwanted deposition of coating material on the backside of the glass substrate can be further reduced due to the very small gap width.

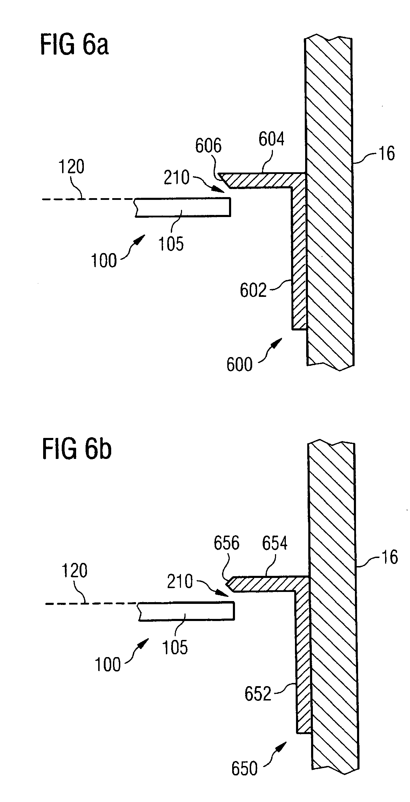

In further examples according to embodiments described herein and shown in Figs. 6a and 6b, respectively, the screens of Figs. 4a and 4b are modified to include tapered lateral ends. The example of Fig. 6a includes a branch 602 attached to the sidewall 16 and a branch 604 protruding above the substrate front plane 120. The lateral end 606 of branch 604 has a wedge-shaped slanted face such that the protruding tip thereof is directed towards the top of the coating chamber 10. Screen 650 of the example shown in Fig. 6b has two branches 652 and 654, wherein branch 654 protrudes substantially in parallel to the substrate front plane 120, and branch 652 is attached to the sidewall 16. In addition, the lateral end 656 of branch 654 has a tapered form such that the protruding central tip thereof is directed towards the opposing sidewall 16 of the coating chamber 10. The tapered lateral ends 606 and 656 of the backside coating prevention device of the examples as shown in Figs. 6a and 6b result in an improved clearance of the glass substrate during transport, such that contact or collisions of the glass substrate with the screens 600, 650 are prevented.

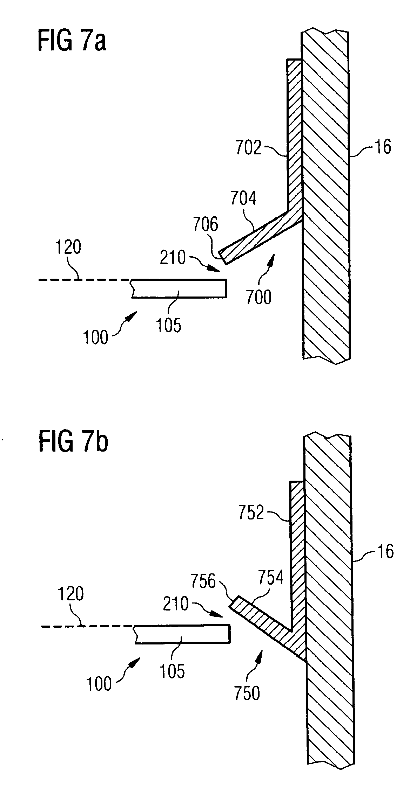

In Figs. 7a and 7b, embodiments of the backside coating prevention device are shown, comprising screens having protruding members being inclined with respect to the sidewalls 16. The inclination of the protruding members is in these embodiments different from 90 degrees. In other words, the protruding members are not substantially perpendicular with respect to the sidewall but are slanted. According to the example of Fig. 7a, a branch 702 of a screen 700 is attached to the sidewall 16, while a slanted branch 704 is mounted facing downwards at the bottom end of branch 702. Branch 702 is mounted to the sidewall 16 at such an installation height that a protruding lateral end 706 of branch 704 is spaced in the range from 1.5 mm to 5 mm from the front side of the glass substrate 100, while it is directed towards the front side 110 of the glass substrate 100. In other words, gap 210 has a width in the range from 1.5 mm to 5 mm. Accordingly, in the example of Fig. 7b, a branch 754 of a screen 750 is attached in an inclined way at a bottom end of a branch 752 mounted at the sidewall 16, slanted branch 754 facing upwards. The installation height of branch 752 is such that a protruding lateral end 756 of branch 754 is spaced in the range from 1.5 mm to 5 mm from and above the front side of the glass substrate 100. In other words, gap 210 has a width in the range from 1.5 mm to 5 mm. Again, backside coating of the glass substrate 100 is reduced or prevented, since the resulting small width of the gaps 210 between screens 700 and 750, respectively, and the glass substrate 100 during transport reduces or inhibits passage of sputtered Ag particles to the backside of the glass substrate 100.

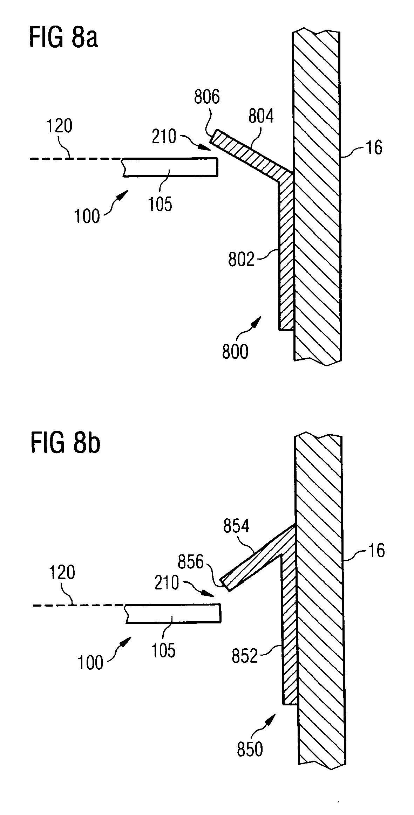

Figures 8a and 8b, respectively, show other examples of backside coating prevention devices according to embodiments described herein. In the example of Fig. 8a, a branch 802 of a screen 800 is mounted at the sidewall 16 while a branch 804 is attached to the top end of branch 802 in an inclined way with respect to branch 802. The inclination of the protruding member, i.e. of branch 804 in this example, is different from 90 degrees. Branch 802 is mounted to sidewall 16 below the substrate front plane 120. Branch 804 is further directed upwards such that its lateral end 806 is positioned above the lateral side 114 of glass substrate 100. In the example shown in Fig. 8b, branch 852 is attached to the sidewall at such an installation height that it is facing the lateral side 114 of glass substrate 100. Branch 852 is mounted to sidewall 16 and extends across substrate front plane 120 into the upper portion, e.g. in the coating region, of the coating chamber. An inclined branch 854 having a lateral end 856 is mounted at the top end of branch 852 and is directed downwards to the front side of the glass substrate 100. Branches 804 and 854 are each about 1.5 to about 10 mm, typically about 1.5 to about 5 mm, most typically about 2 mm spaced apart from the front side 110 of the glass substrate 100. Because of the resulting small width of the gaps 210 between the screens 800 and 850, respectively, and the glass substrate 100 on the transport system, both embodiments allow for a reduced or prevented backside coating of the glass substrate 100.

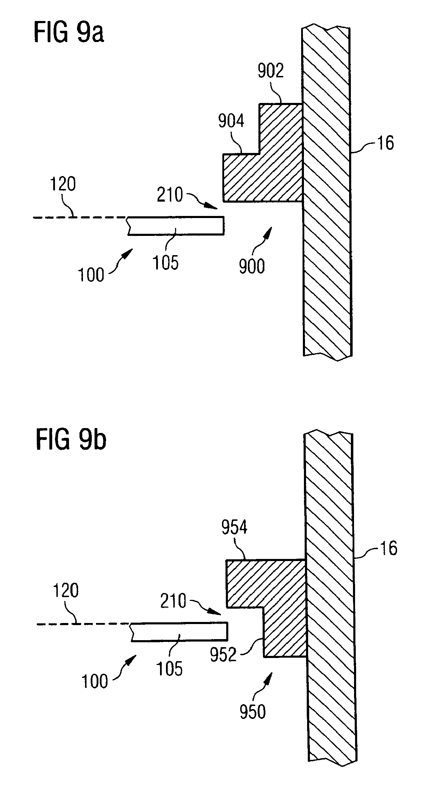

In other embodiments of the backside coating prevention device, the screens may have protruding members formed by a variation of the thickness of the screens. For instance, examples of the backside coating prevention device shown in Figs. 9a and 9b, respectively, have stepped cross-sectional shapes. That means that, as is shown in Fig. 9a, a screen 900 is a panel 902 comprising a protrusion 904 at its bottom end. Thereby, a stepped screen 900 is formed, which is mounted at an installation height at sidewall 16 such that protrusion 904 is positioned spaced from and above glass substrate 100 during transport. Typically, the gap width of gap 210 between the bottom surface of protrusion 904 and substrate front plane 120 is in the range of 1.5 mm to 5 mm, more typically about 2 mm. Screen 950 shown in Fig. 9b is similar to screen 900 but mounted in an inverted way as compared to the example of Fig. 9a. Screen 950 includes a panel 952 having a protrusion 954 protruding from the top end of panel 952. Panel 952 is mounted at the sidewall 16 at such installation height that protrusion 954 has an bottom surface extending substantially in parallel to and being spaced apart from the front side of glass substrate 100. Typically, the gap width of gap 210 between the bottom surface of protrusion 954 and substrate front plane 120 is in the range of 1.5 mm to 5 mm, more typically about 2 mm. Both examples result in a reliable reduction or prevention of a backside coating of glass substrate 100 because of the small width of the gaps 210 between screens 900 and 950, respectively, and the front side of glass substrate 100 in the range from 1.5 to 5 mm, typically about 2 mm. Moreover, screens 900 and 950 additionally shield a part of the sidewall 16 facing the lateral side 114 of the glass substrate, thus preventing contamination of the sidewall 16 by coating material in this area of the sidewall 16.

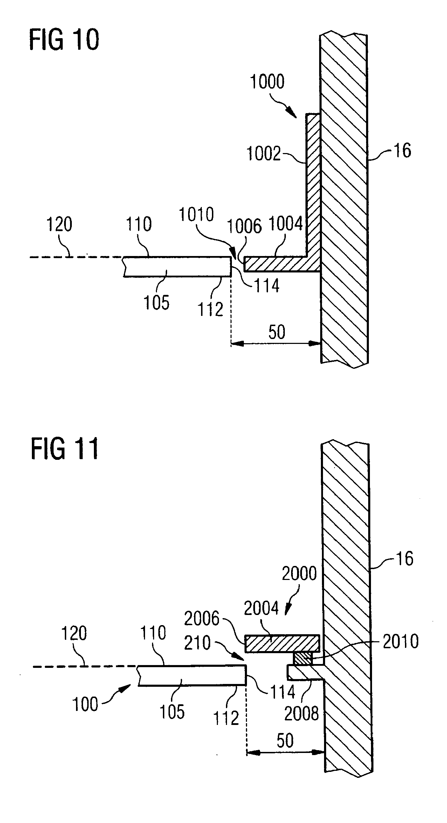

According to embodiments disclosed herein, the backside coating prevention device may have screens each comprising a protruding member being substantially aligned with the substrate. Furthermore, according to embodiments described herein, the backside coating prevention device may have screens each comprising a protruding member being substantially aligned with the substrate front plane 120. An example of these embodiments is shown in Fig. 10.

According to Fig. 10, a screen 1000 comprises a branch 1002 attached to the sidewall 16 of the coating chamber 10 and a branch 1004 formed as a protruding member. Branch 1004 is mounted at the bottom end of branch 1002 and protrudes into the coating chamber 10. Branch 1004 has a lateral end 1006 facing the lateral side 114 of the glass substrate 100. The installation height of branch 1004 may be adjusted so that the upper side of branch 1004 is substantially aligned with the substrate front plane 120, as shown in Fig. 10. Further in this example, screen 1000 is L-shaped, i.e. branches 1002 and 1004 are arranged substantially perpendicularly to each other. The length of branch 1004 is such that its lateral end 1006 is laterally spaced from the lateral side 114 of the glass substrate 100 by about 1.5 to about 10 mm, typically about 1.5 to about 5 mm, and most typically about 2 mm. As a result, only a small lateral gap 1010 having a width of about 1.5 to about 10 mm, typically about 1.5 to about 5 mm, and most typically about 2 mm is provided between branch 1004 and the lateral side 114 of the glass substrate 100. Through this gap 1010, only a negligible amount of Ag particles ejected from the sputtering cathodes 26 will pass.

Therefore, when using in a coating process a backside coating prevention device including two screens 1000 according to the example shown in Fig. 10, substantially all Ag coating particles travelling towards the gaps 50 between the glass substrate 100 and the sidewalls 16 are deposited on the upper surfaces of the protruding branches 1004. Hence, by providing screens 1000 on both sidewalls 16 of the coating chamber, passage of Ag particles through the gaps 50 between the glass substrates 100 and the sidewalls 16 towards the backside 105 of the glass substrate 100 is reduced or substantially inhibited.

Hence, according to embodiments disclosed herein, the protruding member may be substantially aligned with the substrate front plane. As shown in the example of Fig. 10, the installation height of branch 1004 may be adjusted so that the upper side of branch 1004 is substantially aligned with the substrate front plane 120, resulting in a first position of the protruding member. In other examples, the installation height of branch 1004 shown in Fig. 10 may be adjusted so that the lower side of branch 1004 is substantially aligned with the substrate front plane 120, resulting in a second position of the protruding member. Furthermore, the protruding member may be installed at any other position substantially aligning the protruding member with the substrate front plane. For example, the installation height of branch 1004 shown in Fig. 10 may be adjusted so that the protruding member is positioned between the first and the second position of the protruding member. Typically, the lateral end of the protruding member may be positioned on the substrate front plane. For instance, the upper part of the lateral end 1006 of the branch 1004 shown in Fig. 10 is positioned on the substrate front plane 120. Alternatively, other parts of the lateral end 1006 may be positioned on the substrate front plane 120.

Moreover, in embodiments disclosed herein, the protruding member may be positioned such that it is aligned with the substrate. Hence, the protruding member may have any position in which it is positioned opposite to, e.g. facing, a lateral side of a substrate supported on the substrate support. For instance, in a variation of the example shown in Fig. 10, branch 1004 may have any position in which the lateral end 1006 of the branch 1004 may face, at least partially, the lateral side 114 of the substrate 100.

In variations of the example shown in Fig. 10, the screens of the backside coating prevention device may each have a protruding branch arranged in an inclined way with an inclination different from 90 degrees with respect to the sidewall 16. Furthermore, for each screen the branch which is attached to the sidewall 16 may be mounted thereon at such an installation height, and the protruding branch may have such a length, that the lateral end of the protruding branch is positioned at least about 1.5 mm spaced apart from the lateral side 114 of the glass substrate 100. These modifications of the example illustrated in Fig. 10 will also result in a backside prevention effect as mentioned above for the example of Fig. 10.

In an alternative embodiment of the example shown in Fig. 10, the screens of the backside coating prevention device do not include a protruding branch 1004. Instead, only a single branch 1002 is provided and extends across substrate front plane 120. Thus, a gap is formed between a lateral surface of branch 1002 and lateral side 114 of the glass substrate. In this embodiment, the thickness of branch 1002 is adjusted so that the width of the gap formed between branch 1002 and lateral side 114 is about 1.5 to about 10 mm, typically about 1.5 to about 5 mm, and most typically about 2 mm. Thus, it is not necessary to provide a screen with a specific profile but, alternatively, a plain panel having a specific thickness may be provided as the backside coating prevention device.

Furthermore, it will be understood by those skilled in the art that in the above embodiments described with reference to Fig. 10, i.e. the embodiments having a lateral gap 1010 instead of a vertical gap 210, the dimensions of the branches, especially of the protruding branches, will be adjusted with respect to the width and the thickness of the glass substrates to be coated. Moreover, it will be understood by those skilled in the art that in all embodiments described herein the coating chamber 10 will be designed for glass substrates of specific dimensions so that the dimensions, especially the lengths, of the backside coating prevention devices can be specifically adjusted to those dimensions of the substrates. Thus, by knowing the dimensions of the glass substrates for which the chamber is designed, the skilled person can determine the correct dimensions of the backside coating prevention devices so that a specific gap width is achieved in the chamber during operation.

Furthermore, according to embodiments described herein, the backside coating prevention device may have screens each comprising a protruding member comprising a panel and a holder, the holder being provided at a respective wall. The panel may be provided at the holder. The panel may be an elongated panel. The holder may be an elongated holder or may include a plurality of holder elements. The holder may be a protruding integral part of the respective wall. Alternatively, the holder may be a member provided at the respective wall.

Hence, as illustrated in Fig. 11 showing a cross-sectional view of one example of embodiments described herein, a screen 2000 may be an elongated panel 2004 mounted at its lower side at fixture 2010 of an elongated holder 2008 protruding from a side wall 16. According to another example (not shown), the lower side of panel 2004 may be directly attached to the holder 2008, with no fixture or spacing between the lower side of the panel 2004 and the upper side of holder 2008. The panel 2004 may extend substantially in parallel to the transport path 60 and, hence, to the substrate front plane 120. As illustrated in Fig. 11, the holder 2008 may be an elongated protrusion of the side wall 16. Hence, it may be an integral part of the side wall 16, as shown in Fig. 11. Alternatively, the holder 2008 may be an elongated member attached at the sidewall 16. According to the example shown in Fig. 11, the holder 2008 and the panel 2004 extend along the sidewall 16 in parallel to each other and in parallel to the transport path 60. Furthermore, in the present example, the dimensions of panel 2004 are such that a front side 2006 of the panel 2004 is substantially aligned with the lateral side 114 of the substrate 100. Typically, the holder 2008 may be provided at an installation height at sidewall 16 such that the lower side of panel 2004 is positioned spaced from and above glass substrate 100 during transport, such that the gap 210 is formed between the panel 2004 and the substrate 100. The gap width of the gap 210 between the bottom surface of the panel 2004 and the substrate front plane 120 is in the range of about 1.5 mm to 5 mm, more typically about 2 mm. According to a specific design of the screen 2000 as shown in Fig. 11, the holder 2008 may be provided at the sidewall 16 in an installation height such that the upper side of the holder 2008 is substantially aligned with the front side 110 of the substrate and, at the same time, the gap 210 is formed between the panel 2004 and the substrate 100. Each above mentioned design of the example shown in Fig. 11 results in a reliable reduction or prevention of a backside coating of glass substrate 100, because of the small width of the gaps 210 between screen 2000 and the front side of glass substrate 100 in the range from about 1.5 to 5 mm, typically about 2 mm.

In a modification of the backside coating prevention device, in the above embodiments and examples, respectively, the edges of the protruding members 204, 304, 404, 454, 504, 554, 604, 654, 704, 754, 804, 854, and 1004 as well as of the panels 900, 950, and 2004 and of the holder 2008 may have a rounded from, in order to avoid sharp edges which might damage the glass substrates 100 in case of vibrations or sagging during transport.

Moreover, in another modification of the above embodiments and examples, respectively, the coating chamber 10 may be a tube-shaped vessel having a tube-shaped wall closed by circular front and rear lids, the glass substrates 100 being transported in a direction parallel to the longitudinal axis of the tube-shaped vessel, the circular front and rear lids being the front and rear walls as defined above, the sidewalls as defined above being the areas of the tube-shaped wall facing the lateral ends of the glass substrates during transport.

Furthermore, in each of the above embodiments and examples also one or more additional screens having a shape as described above in any of the embodiments and examples, respectively, may be provided at each sidewall 16 above and/or below the substrate front plane 120, i. e. above and/or below the screens 200, 300, 400, 450, 500, 550, 600, 650, 700, 750, 800, 850, 900, 950, 1000 and 2000, typically substantially in parallel thereto. Thereby, prevention of backside coating of the glass substrates 100 is promoted.

In addition, in further variations of the above embodiments and examples, respectively, the substrates 100 may be conveyed vertically instead of horizontally through the coating chamber. In such a case, as will be understood by the skilled person, the screens may be installed at other positions in the coating chamber, e.g. at the top and the bottom wall of the coating chamber, or may have correspondingly adapted modified profiles, in order to allow an installation at the sidewalls.

According to one embodiment, a backside coating prevention device adapted for a coating chamber for coating plate-shaped substrates is provided, said coating chamber comprising a plurality of walls, a coating material source adapted for dispensing coating material into the coating chamber, a substrate support, a front side of the substrate support facing the coating material source, the substrate support being adapted for supporting on the front side one or more plate-shaped substrates each having a substrate front side and thereby defining a substrate front plane, wherein said backside coating prevention device comprises two or more screens, the screens being provided at at least two of the walls of the coating chamber, each screen having a protruding member protruding from the respective wall.

In a modification of the above embodiment, said protruding member is positioned to be spaced in the range from 1.5 mm to 5 mm from the one or more plate-shaped substrates during coating.

In a modification of any of the above embodiment and the above modification thereof, said protruding member protrudes from the respective wall such that the protruding member is positioned between the coating material source and the substrate front plane.

In a modification of any of the above embodiment and the above modifications thereof, said protruding member is substantially aligned with the substrate front plane.

According to a further embodiment, a coating chamber for coating plate-shaped substrates comprises a plurality of walls, a coating material source adapted for dispensing coating material into the coating chamber, a substrate support, a front side of the substrate support facing the coating material source, the substrate support being adapted for supporting on the front side one or more plate-shaped substrates each having a substrate front side and thereby defining a substrate front plane, and a backside coating prevention device comprising two or more screens, the screens being provided at at least two of the walls of the coating chamber, each screen having a protruding member protruding from the respective wall.

In a modification of the above further embodiment, said protruding member is positioned to be spaced in the range from 1.5 mm to 5 mm from the one or more plate-shaped substrates during coating.

In a modification of any of the above further embodiment and the above modification thereof, said protruding member protrudes from the respective wall such that the protruding member is positioned between the coating material source and the substrate front plane.

In a modification of any of the above embodiments and the above modifications thereof, the substrate front side of each of said one or more plate-shaped substrates is to be coated and faces the coating material source during coating, said one or more plate-shaped substrates each having a backside, which is opposite to the substrate front side and faces the substrate support during being supported thereon, and two lateral sides, said protruding member has a lateral end protruding into the coating chamber, said lateral end being positioned to be spaced apart from but substantially aligned with one of the lateral sides of at least one of the one or more plate-shaped substrates on the substrate support, or said lateral end being positioned to extend over a lateral part of the substrate front side of at least one of the one or more plate-shaped substrates on the substrate support.

In a modification of any of the above embodiments and the above modifications thereof, said lateral end is formed to taper away from the substrate front side of a plate-shaped substrate on the substrate support.

In a modification of any of the above embodiments and the above modifications thereof, said protruding member is substantially aligned with the substrate front plane.

In a modification of any of the above embodiments and the above modifications thereof, each screen comprises a first branch and a second branch, said first branch being attached to one of the walls and said second branch forming the protruding member.

In a modification of any of the above embodiments and the above modifications thereof, said first and second branches are arranged substantially perpendicularly to each other.

In a modification of any of the above embodiments and the above modifications thereof, said coating material source is adapted to dispense coating material at least into a coating region of the coating chamber and each screen is provided at least in the coating region.

In a modification of any of the above embodiments and the above modifications thereof, said coating chamber is adapted for coating continuously or discontinuously transported plate-shaped substrates, the substrate support being a transport system adapted for continuously or discontinuously transporting the plate-shaped substrates along a transport path, said backside coating prevention device being provided at two opposite sidewalls of the coating chamber and comprising at least two of the screens, each of the two sidewalls being provided with at least one screen thereof, each screen having the protruding member protruding from the respective sidewall.

In a modification of any of the above embodiments and the above modifications thereof, said protruding member extends along the respective sidewall substantially in parallel to the transport path.

In a modification of any of the above embodiments and the above modifications thereof, said coating chamber is adapted for coating by sputtering, the coating material source being a sputtering cathode.

According to another embodiment, a method of coating plate-shaped substrates in a coating chamber is provided, comprising providing a plate-shaped substrate on a substrate support of the coating chamber, dispensing coating material from a coating material source provided in the coating chamber towards the plate-shaped substrate, and simultaneously preventing backside coating by two or more screens, the screens being provided at at least two walls of the coating chamber, each screen having a protruding member protruding from the respective wall.

In a modification of the above another embodiment, said preventing of backside coating is effected by said screens, each screen having the protruding member being positioned so that each protruding member is spaced in the range from 1.5 mm to 5 mm from the plate-shaped substrate during coating.

In a modification of any of the above another embodiment and the above modification thereof, said preventing of backside coating is effected by said screens, each screen having the protruding member protruding from the respective wall such that the protruding member is positioned between the coating material source and the plate-shaped substrate.

In a modification of any of the above another embodiment and the above modifications thereof, said plate-shaped substrate has a substrate front side to be coated and facing the coating material source during coating, a backside opposite to the front side and facing the substrate support during being supported thereon, and two lateral sides, said protruding member has a lateral end protruding into the coating chamber, said lateral end being spaced apart from but substantially aligned with one of the lateral sides of the plate-shaped substrate on the substrate support, or said lateral end extending over a lateral part of the substrate front side of the plate-shaped substrate on the substrate support.

In a modification of any of the above another embodiment and the above modifications thereof, said lateral end is tapering away from the front side of the plate-shaped substrate.

In a modification of any of the above another embodiment and the above modifications thereof, said plate-shaped substrate has a substrate front side to be coated and thereby defines a substrate front plane, and wherein said protruding member is substantially aligned with the substrate front plane.

In a modification of any of the above another embodiment and the above modifications thereof, each screen comprises a first branch and a second branch, said first branch being attached to one of the walls and said second branch forming the protruding member.

In a modification of any of the above another embodiment and the above modifications thereof, said first and second branches are arranged substantially perpendicularly to each other.

A modification of any of the above another embodiment and the above modifications thereof comprises providing the plate-shaped substrate by feeding the plate-shaped substrate into the coating chamber and arranging the plate-shaped substrate on the substrate support, the substrate support being a transport system for continuously or discontinuously transporting the plate-shaped substrate along a transport path, continuously or discontinuously transporting the plate-shaped substrate by the transport system along the transport path, while dispensing coating material from the coating material source and preventing backside coating of the plate-shaped substrate by at least two of the screens provided at two opposite sidewalls of the coating chamber, each of the two sidewalls being provided with at least one screen thereof, said protruding member of each screen extending along the respective sidewall substantially in parallel to the transport path, and discharging the plate-shaped substrate from the coating chamber.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the embodiments described above may be combined with each other. The patentable scope of the invention is defined by the claims, and may include other examples that occur to those skilled in the art. Such other examples are intended to be within the scope of the claims.

## Claims

1. A backside coating prevention device adapted for a coating chamber for
coating plate-shaped substrates,
said coating chamber comprising
a plurality of walls,
a coating material source adapted for dispensing coating material into the coating chamber,
a substrate support, a front side of the substrate support facing the coating material source, the substrate support being adapted for supporting on the front side one or more plate-shaped substrates each having a substrate front side and thereby defining a substrate front plane,
wherein
said backside coating prevention device comprises two or more screens, the screens being provided at at least two of the walls of the coating chamber, each screen having a protruding member protruding from the respective wall.

2. A coating chamber device for coating plate-shaped substrates, the coating chamber device being a coating chamber comprising
a plurality of walls,
a coating material source adapted for dispensing coating material into the coating chamber,
a substrate support, a front side of the substrate support facing the coating material source, the substrate support being adapted for supporting on the front side one or more plate-shaped substrates each having a substrate front side and thereby defining a substrate front plane, and
a backside coating prevention device comprising two or more screens,
the screens being provided at at least two of the walls of the coating chamber, each screen having a protruding member protruding from the respective wall.

3. The device according to any of the preceding claims, wherein said protruding member is positioned to be spaced in the range from 1.5 mm to 5 mm from the one or more plate-shaped substrates during coating.

4. The device according to any of the preceding claims, wherein said protruding member protrudes from the respective wall such that the protruding member is positioned between the coating material source and the substrate front plane.

5. The device according to claim 4, wherein
the substrate front side of each of said one or more plate-shaped substrates is to be coated and faces the coating material source during coating, said one or more plate-shaped substrates each having a backside, which is opposite to the substrate front side and faces the substrate support during being supported thereon, and two lateral sides,
said protruding member has a lateral end protruding into the coating chamber,
said lateral end being positioned to be spaced apart from but substantially aligned with one of the lateral sides of at least one of the one or more plate-shaped substrates on the substrate support, or
said lateral end being positioned to extend over a lateral part of the substrate front side of at least one of the one or more plate-shaped substrates on the substrate support,
wherein said lateral end is optionally formed to taper away from the substrate front side of a plate-shaped substrate on the substrate support.

6. The device according to any of the preceding claims, wherein each screen comprises a first branch and a second branch, said first branch being attached to one of the walls and said second branch forming the protruding member, wherein said first and second branches are optionally arranged substantially perpendicularly to each other.

7. The device according to any of the preceding claims, wherein said coating material source is adapted to dispense coating material at least into a coating region of the coating chamber and each screen is provided at least in the coating region.

8. The device according to any of the preceding claims, said coating chamber being adapted for coating continuously or discontinuously transported plate-shaped substrates,
the substrate support being a transport system adapted for continuously or discontinuously transporting the plate-shaped substrates along a transport path,
said backside coating prevention device being provided at two opposite sidewalls of the coating chamber and comprising at least two of the screens, each of the two sidewalls being provided with at least one screen thereof, each screen having the protruding member protruding from the respective sidewall, wherein said protruding member optionally extends along the respective sidewall substantially in parallel to the transport path.

9. The device according to any of the preceding claims, wherein said coating chamber is adapted for coating by sputtering, the coating material
source being a sputtering cathode.

10. A method of coating plate-shaped substrates in a coating chamber, comprising
providing a plate-shaped substrate on a substrate support of the coating chamber,
dispensing coating material from a coating material source provided in the coating chamber towards the plate-shaped substrate, and simultaneously preventing backside coating by two or more screens, the screens being provided at at least two walls of the coating chamber, each screen having a protruding member protruding from the respective wall.

11. The method according to claim 10, wherein said preventing of backside coating is effected by said screens, each screen having the protruding member being positioned so that each protruding member is spaced in the range from 1.5 mm to 5 mm from the plate-shaped substrate during coating.

12. The method according to claim 10 or 11, wherein said preventing of backside coating is effected by said screens, each screen having the protruding member protruding from the respective wall such that the protruding member is positioned between the coating material source and the plate-shaped substrate.

13. The method according to claim 12, wherein
said plate-shaped substrate has a substrate front side to be coated and facing the coating material source during coating, a backside opposite to the front side and facing the substrate support during being supported thereon, and two lateral sides,
said protruding member has a lateral end protruding into the coating chamber, said lateral end being spaced apart from but substantially aligned with one of the lateral sides of the plate-shaped substrate on the substrate support, or
said lateral end extending over a lateral part of the substrate front side of the plate-shaped substrate on the substrate support,
wherein said lateral end is optionally tapering away from the front side of the plate-shaped substrate.

14. The method according to any of claims 10 to 13, wherein each screen comprises a first branch and a second branch, said first branch being attached to one of the walls and said second branch forming the protruding member, wherein said first and second branches are optionally arranged substantially perpendicularly to each other.

15. The method according to any of claims 10 to 14, comprising
providing the plate-shaped substrate by feeding the plate-shaped substrate into the coating chamber and arranging the plate-shaped substrate on the substrate support, the substrate support being a transport system for continuously or discontinuously transporting the plate-shaped substrate along a transport path,
continuously or discontinuously transporting the plate-shaped substrate by the transport system along the transport path, while dispensing coating material from the coating material source and preventing backside coating of the plate-shaped substrate by at least two of the screens provided at two opposite sidewalls of the coating chamber, each of the two sidewalls being provided with at least one screen thereof, said protruding member of each screen extending along the respective sidewall substantially in parallel to the transport path, and
discharging the plate-shaped substrate from the coating chamber.
